# EUROPÄISCHE PATENTANMELDUNG

(11) **EP 2 418 499 A2**
(43) Veröffentlichungstag der Anmeldung: **15.02.2012**
(21) Anmeldenummer: 11006552.1
(22) Anmeldetag: 09.08.2011
(51) Int. Cl.: G01R 15/20

(54) **Anschluss- und Messvorrichtung, Leiterplatte und Sensorvorrichtung**

(30) Priorität: 09.08.2010 DE 102010033813
(71) Anmelder: Würth Elektronik ICS GmbH & Co. KG, 74613 Öhringen (DE)
(72) Erfinder: Faber, Albrecht, 84307 Eggenfelden (DE); Hoffmann, Franz-Josef, Dayton OH 45414 (US); Wittig, Klaus, Dr., 74613 Öhringen / Kappel (DE); Wunder, Stefan, 74189 Weinsberg (DE)
(74) Vertreter: Schatt, Markus F.

(57) **Zusammenfassung**

Die vorliegende Erfindung betrifft eine Anschluss- und Messvorrichtung für den elektrischen Anschluss einer Stromversorgungsleitung an eine Leiterplatte und die Überwachung des der Leiterplatte über die Anschluss- und Messvorrichtung zugeführten elektrischen Stroms, eine Leiterplatte und eine Sensorvorrichtung. Die erfindungsgemäße Anschluss- und Messvorrichtung kombiniert dabei den Anschluss der Stromversorgungsleitung mit einer Sensorvorrichtung, die direkt an der Anschluss-und Messvorrichtung die Stromversorgung überwacht.

## Beschreibung

Diese Patentanmeldung beansprucht den Anmeldetag der deutschen Patentanmeldung DE 10 2010 033 813.3, die am 09.08.2010 eingereicht worden ist. Durch die hiermit vorgenommene Bezugnahme ist die Offenbarung dieser Patentanmeldung in der hier vorliegenden Patentanmeldung enthalten.Die vorliegende Erfindung betrifft eine Anschluss- und Messvorrichtung für den elektrischen Anschluss einer Stromversorgungsleitung an eine Leiterplatte und die Überwachung des der Leiterplatte über die Anschluss- und Messvorrichtung zugeführten elektrischen Stroms, eine Leiterplatte und eine Sensorvorrichtung.

Anschlussvorrichtungen für den elektrischen Anschluss einer Stromversorgungsleitung an Leiterplatten sind grundsätzlich bekannt, die als sockelförmige Kopplungsteile ausgebildet und am Rand einer Leiterplatte vorgesehen sind, um eine Stromversorgungsleitung aufzunehmen.

Es ist Aufgabe der vorliegenden Erfindung, eine Anschluss- und Messvorrichtung, eine Leiterplatte mit einer sochen und eine entsprechende Sensorvorrichtung für die Anschluss- und Messvorrichtung zur Verfügung zu stellen, die neben dem elektrischen Anschluss einer Stromversorgungsleitung an eine Leiterplatte auch eine Überwachung derselben ermöglicht. Darüber hinaus ist es Aufgabe der vorliegenden Erfindung, eine solche Anschluss- und Messvorrichtung in einer möglichst kompakten Bauform herzustellen, wobei insbesondere auch die Funktion der mechanischen Anschlusssicherheit erfüllt werden soll.

Die vorliegende Aufgabe wird gelöst durch die Merkmale der unabhängigen Ansprüche. Vorteilhafte Ausgestaltungen ergeben sich aus den auf die jeweiligen unabhängigen Ansprüche rückbezogenen Unteransprüche.

Die erfindungsgemäße Anschluss- und Messvorrichtung für den elektrischen Anschluss und die Überwachung einer Energie- und insbesondere Stromversorgungsleitung an einer Leiterplatte zur Bereitstellung einer Energieversorgung kombiniert den Anschluss der Stromversorgungsleitung mit einer Sensorvorrichtung, die direkt an der Anschluss- und Messvorrichtung die Stromversorgung überwacht. Die erfindungsgemäße Anschluss- und Messvorrichtung stellt eine Messung des elektrischen Stroms, mit welchem die Leiterplatte versorgt wird, bereit. Bei der erfindungsgemäßen Lösung sind keine aufwendige Messinstrumente auf der Leiterplatte erforderlich, um den elektrischen Strom zu messen, so dass auch vermieden wird, dass direkt an der Stromversorgungsleitung, also direkt am Anschluss der Strom gemessen werden muss und dass in diesem Fall Verfälschungen der Messung eintreten können. Die erfindungsgemäße Lösung erlaubt eine relativ kleine Bauweise derselben, so dass mit dieser der Platzbedarf der gesamten Leiterplatte in deren Einbausituation vergrößert ist.

Eine erfindungsgemäße Anschluss- und Messvorrichtung für den elektrischen Anschluss und die Überwachung einer Stromversorgung an einer Leiterplatte weist dabei ein sockelförmiges Kopplungsteil sowie eine Sensorvorrichtung auf. Das sockelförmige Kopplungsteil ist mit einem an einem ersten Sockelende ausgebildeten Leitungs-Anschlussabschnitt für den Anschluss der Stromversorgung ausgestattet. An einem zweiten Sockelende des sockelförmigen Kopplungsteils ist ein Leiterplatten-Anschlussabschnitt für den Kontakt mit der Leiterplatte ausgebildet. Zwischen dem Leitungs-Anschlussabschnitt und dem Leiterplatten-Anschlussabschnitt ist eine elektrische Verbindung zur elektrischen Kopplung vorgesehen. Die elektrische Verbindung kann dabei zum Beispiel durch das Material des sockelförmigen Kopplungsteils selbst ausgebildet sein. So ist es möglich, dass das sockelförmige Kopplungsteil zumindest teilweise aus einem elektrisch leitfähigen Material hergestellt ist. Dieses elektrisch leitfähige Material erstreckt sich zumindest zwischen dem Leitungs-Anschlussabschnitt und dem Leiterplatten-Anschlussabschnitt, so dass zwischen diesen beiden Anschlussabschnitten eine elektrische Verbindung zur elektrischen Kopplung dieser beiden Abschnitte hergestellt ist. Jedoch ist es im Rahmen der vorliegenden Erfindung auch möglich, dass die elektrische Verbindung zur elektrischen Kopplung des Leitungs-Anschlussabschnitts mit dem Leiterplatten-Anschlussabschnitt über separate elektrische Verbindungsmittel im Inneren der Anschluss- und Messvorrichtung, im einfachsten Fall über eine Kabelverbindung erfolgt. Eine solche Kabelverbindung kann darüber hinaus mit einer isolierenden Schicht umgeben sein, so dass eine elektrische Isolation des Kabels, also der elektrischen Verbindung nach außen erfolgt.

Die Sensorvorrichtung einer erfindungsgemäßen Anschluss- und Messvorrichtung weist nach der vorliegenden Erfindung einen die elektrische Verbindung umlaufenden und eine Ausnehmung aufweisendes Magnetflussmedium auf. In der Ausnehmung ist ein Hall-Sensor angeordnet, der mit einem Anschluss zu einer elektrischen Messsignalleitung ausgestattet ist. Damit ist es möglich, dass der Hall-Sensor in Abhängigkeit von der Stärke des im Magnetflussmedium induzierten Magnetfeldes ein elektrisches Signal erzeugt. Mit anderen Worten umgibt ein Magnetflussmedium, welcher zum Beispiel aus einem ferromagnetischen Material, zum Beispiel auch in Form eines Permanentmagneten, ausgestaltet sein kann, die elektrische Verbindung des sockelförmigen Kopplungsteils. Damit umgibt das Magnetflussmedium den Bereich des sockelförmigen Kopplungsteils, durch welchen der elektrische Strom von der Stromversorgungsleitung zur Leiterplatte fließt. Da dies die einzige elektrische Verbindung zwischen der Stromversorgungsleitung und der Leiterplatte ist, ist damit sichergestellt, dass der gesamte elektrische Strom, mit welchem die Leiterplatte versorgt wird, durch die elektrische Verbindung geführt wird und damit auch vom Magnetflussmedium der Sensorvorrichtung erfasst werden kann. Dadurch ergibt sich die im folgenden beschriebene Induktionskopplung zwischen dem Magnetflussmedium und der elektrischen Verbindung des sockelförmigen Kopplungsteils.

Durch den Fluss oder die Bewegung der Elektronen innerhalb des sockelförmigen Kopplungsteils wird um das sockelförmige Kopplungsteil herum ein Magnetfeld induziert. Dieses Magnetfeld verändert bzw. beeinflusst das Magnetfeld, welches vom Magnetflussmedium aufrecht erhalten wird. Die Veränderung dieses Magnetfelds des Magnetflussmediums ist demnach direkt abhängig von der Strommenge, welche durch die elektrische Verbindung des sockelförmigen Kopplungsteils fließt. Der Hall-Sensor ist durch seine Anordnung in der Ausnehmung der Sensorvorrichtung in der Lage, die Schwankungen des Magnetfelds im Magnetflussmedium wahrzunehmen, insbesondere mit einem davon abhängigen elektrischen Signal zu versehen. Mit anderen Worten dient der Hall-Sensor zur indirekten Messung des elektrischen Stroms in der elektrischen Verbindung des sockelförmigen Kopplungsteils. Die indirekte Messung ist deswegen indirekt, weil der Hall-Sensor Schwankungen des Magnetfelds im Magnetflussmedium wahrnimmt, welche wiederum auf Änderungen des elektrischen Stroms in der elektrischen Verbindung des sockelförmigen Kopplungsteils abhängen.

Damit ist es möglich, dass die Sensorvorrichtung unabhängig vom sockelförmigen Kopplungsteil ausgestaltet sein kann, da keine kontaktierende Verbindung erforderlich ist. Weiter ist es auf diese Weise möglich, dass die Sensorvorrichtung mit einer relativ kompakten Bauweise um das sockelförmigen Kopplungsteil herum vorgesehen ist. Im Vergleich zu bekannten Anschlussvorrichtungen gemäß des Standes der Technik werden damit zwei entscheidende Vorteile erzielt. Zum einen ist es möglich, dass direkt am Anschluss der Stromversorgungsleitung an die Leiterplatte die Gesamtmenge des elektrischen Stroms, mit welchem die Leiterplatte versorgt wird, gemessen wird. Darüber hinaus ist es möglich, das Bauvolumen der Sensorvorrichtung zu reduzieren, insbesondere mit dem Bauvolumen der Anschluss- und Messvorrichtung zu koppeln. Mit anderen Worten wird der Bauraum des sockelförmigen Kopplungsteils, welcher für den Anschluss der Stromversorgungsleitung auf jeden Fall notwendig ist, durch das Vorstehen einer entsprechenden erfindungsgemäßen Sensorvorrichtung nur um einen Bruchteil erweitert. Damit kann auf eine zusätzliche und von dem sockelförmigen Kopplungsteil separate Sensorvorrichtung für die Überwachung der Stromversorgung der Leiterplatte verzichtet werden, wodurch der Gesamtbauraum einer Leiterplatte mit einer erfindungsgemäßen Anschluss- und Messvorrichtung deutlich reduziert wird.

Unter den Begriffen "Leitungs-Anschlussabschnitt" und "Leiterplatten-Anschlussabschnitt" sind zumindest die Oberflächenbereiche des sockelförmigen Kopplungsteils zu verstehen, welche zum Anschluss an die Stromversorgungsleitung bzw. an die Leiterplatte dienen. Jedoch ist es auch denkbar, dass die jeweiligen Anschlussabschnitte darüber hinaus eine gewisse Dicke aufweisen, bzw. durch ein in sich geschlossenes Material gebildet sein können. In einer besonders vorteilhaften Ausführungsform ist es also denkbar, dass sowohl der Leitungs-Anschlussabschnitt, als auch der Leiterplatten-Anschlussabschnitt, sowie die elektrische Verbindung zwischen den beiden Anschlussabschnitten integral aus einem einzigen elektrisch leitfähigen Material gebildet werden. Dabei ist vorerst unerheblich, ob die Anschluss-und Messvorrichtung, insbesondere das sockelförmige Kopplungsteil integral mit der Leiterplatte ausgeformt ist oder, wie später noch näher erläutert, mit dieser in einem separaten Arbeitsschritt verbunden wird.

Um mögliche Kurzschlüsse zu verhindern, ist es vorteilhaft, wenn zwischen dem Magnetflussmedium und den jeweiligen Anschlussabschnitten, bzw. der elektrischen Verbindung zur elektrischen Kopplung der Anschlussabschnitte keine elektrisch leitfähige Verbindung besteht, diese Bereiche also voneinander elektrisch isoliert sind. Die elektrische Isolation verhindert nicht nur den Kurzschluss sondern sichert auch, dass keine Fehlmessung erfolgt, da zwischen dem Magnetflussmedium und der elektrischen Verbindung durch die elektrische Isolierung voneinander ausschließlich eine induktive Kopplung besteht.

Das elektrische Signal, welches der Hall-Sensor in Abhängigkeit des im Magnetflussmedium induzierten Magnetfeld abgibt, kann dabei insbesondere ein variierender Stromfluss sein. Dabei ist es möglich, dass am Hall-Sensor eine Spannung angelegt wird, die Stromfluss im Hall-Sensor erzeugt. Dieser Stromfluss hängt in seiner Quantität von dem Magnetfeld ab, in welchem sich der Hall-Sensor befindet. Je nach Magnetfeld wird also der elektrische Strom, welcher durch die am Hall-Sensor angelegte Spannung fließen wird, ansteigen oder abfallen, also variieren. Der Wert des elektrischen Stroms, welcher am Hall-Sensor gemessen werden kann, entspricht somit direkt der Situation des induzierten Magnetfelds im Magnetflussmedium und damit indirekt dem elektrischen Strom, welcher durch die elektrische Verbindung zwischen dem Leitungs-Anschlussabschnitt und dem Leiterplatten-Anschlussabschnitt fließt. Das elektrische Signal ist somit bei einer derartigen Ausführungsform der vorliegenden Erfindung ein elektrischer Strom, welcher vom Hall-Sensor in variierender Weise erzeugt wird. Insbesondere kann der Hall-Sensor wenigstens ein insbesondere stiftförmiges oder stabförmiges elektrisches Kontaktelement aufweisen oder können solche an dem Hall-Sensor angebracht sein, die in entsprechende Kontaktaufnahmen der Leiterplatte einführbar sind, die elektrisch wiederum mit einer insbesondere auf der Leitplatte angeordneten Hall-Sensorverarbeitungsvorrichtung in Verbindung steht. Diese ist derart aufgeführt, dass diese elektrische Signale von dem Hall-Sensor empfängt und aufgrund derselben einen Wert für das induzierte Magnetfeld im Magnetflussmedium ermittelt. Die Hall-Sensorverarbeitungsvorrichtung kann funktional mit einer Kontrolleinrichtung auf der Leiterplatte in Verbindung stehen, die den jeweils ermittelten Wert für das induzierte Magnetfeld einem vorbestimmten Bereich oder mehreren vorbestimmten Bereichen und/oder einem vorbestimmten Grenzwert oder mehreren vorbestimmten Grenzwerten zuordnet, um die Stärke des elektrischen Stroms, welcher durch die elektrische Verbindung zwischen dem Leitungs-Anschlussabschnitt und dem Leiterplatten-Anschlussabschnitt fließt, vorbestimmten Monitor- oder Überwachungsbereichen zuzuordnen. Auf diese Weise kann eine Zuordnung erfolgen, bei der der zu überwachende Strom in einem zulässigen oder in einem unzulässigen und optional einem kritischen Bereich gelegen ist. Die Kontrolleinrichtung kann wiederum mit einer Anzeige funktional verbunden sein, die auf der Leiteplatte angeordnet ist oder mit dieser über eine Daten- oder Signalleitung verbunden ist, um das Gegebensein einer der Bereiche anzuzeigen. Auch kann mit der Kontrolleinrichtung eine Schaltfunktion funtkional verbunden sein, die derart ausgeführt ist, dass eine oder mehrere Funktionen oder Komponenten der Leiterplatte ausgeschaltet oder in einen Ruhezustand versetzt werden, wenn die Stärke des elektrischen Stroms in dem unzulässigen und/oder kritischen Bereich gelegen ist.

Unter dem Begriff "Ausnehmung" ist dabei grundsätzlich zu verstehen, dass in Umfangsrichtung des Magnetflussmediums eine Ausnehmung vorgesehen ist, welche entweder voll durchgängig, also das Magnetflussmedium voll durchtrennend, oder nur zumindest teilweise durchgängig durch das Magnetflussmedium verläuft. In einer solchen Ausnehmung ist somit in Umfangsrichtung des Magnetflussmediums eine Unterbrechung desselben vorgesehen. In dieser Unterbrechung ist der Hall-Sensor angeordnet. Dabei kann es vorteilhaft sein, wenn diese Unterbrechung insbesondere vollständig das Magnetflussmedium unterbricht, also durchtrennt, und damit als Spalt bzw. als Schlitz ausgeformt ist. Eine solche vollständige Trennung weist demnach ein Schlitz auf, welcher zwei gegenüberliegende Enden, bzw. Endoberflächen des Magnetflussmediums aufweist.

Eine erfindungsgemäße Anschluss- und Messvorrichtung kann dahingehend weitergebildet sein, dass die Sensorvorrichtung ringförmig ausgestaltet ist und das Magnetflussmedium der Sensorvorrichtung das sockelförmige Kopplungsteil in einem Umfangsbereich des sockelförmigen Kopplungsteils umgibt, welcher größer oder gleich 180° ist. Unter Ringförmiger Ausgestaltung ist ein ringförmiges Umgeben des sockelförmigen Kopplungsteils durch das Magnetflussmedium zu verstehen. Dabei kann das Magnetflussmedium sowohl unterschiedliche Querschnitte, wie zum Beispiel runde oder rechteckige Querschnitte, als auch unterschiedliche Ringschlussformen, wie zum Beispiel runde oder rechteckige, aufweisen.

Weiter kann es vorteilhaft sein, wenn der Hall-Sensor zwischen den beiden Enden des Magnetflussmediums in Umfangsrichtung angeordnet ist. Gemäß dieser Ausführungsform ist die Ausnehmung im Magnetflussmedium als durchgehender Schlitz definiert. Dieser Schlitz kann bis zu 180° groß sein. Mit anderen Worten ist es möglich, dass das Magnetflussmedium das sockelförmige Kopplungsteil im Bereich der elektrischen Verbindung zur Hälfte umgibt, während innerhalb der anderen Hälfte der Hall-Sensor angeordnet ist. Um die Sensibilität des Hall-Sensors und damit die Sensibilität der gesamten Sensorvorrichtung weiter zu verbessern, ist es jedoch vorteilhaft, wenn der Spalt deutlich geringer ist. Insbesondere ist es vorteilhaft, wenn bei einer erfindungsgemäßen Anschluss- und Messvorrichtung die beiden Enden des Magnetflussmediums in Umfangsrichtung eine Ausnehmung in Form eines Schlitzes bilden, in der der Hall-Sensor angeordnet ist, wobei der Schlitz bezogen auf den Umfang des Anschlusselementes kleiner oder gleich 10° ist. Damit wird der Schlitz besonders klein, da das Magnetflussmedium das sockelförmige Kopplungsteil 350° oder mehr umgibt. Diese kleine Abmessung des Schlitzes hat den Vorteil, dass sich dadurch die Sensibilität des Hall-Sensors erhöht und damit die Wahrnehmung auch kleiner Schwankungen im Magnetfeld, welches in dem Magnetflussmedium induziert wird, wahrzunehmen sind. Die Sensibilität der Sensorvorrichtung steigt damit an. Insbesondere ist der Schlitz auch hier vollständig durchgehend, also das Magnetflussmedium vollständig trennend ausgeführt.

Eine erfindungsgemäße Anschluss- und Messvorrichtung ist vorteilhafterweise derart ausgestaltet, dass die Sensorvorrichtung separat von dem sockelförmigen Kopplungsteil ist. Eine separate Ausgestaltungsform hat zum einen den Vorteil, dass eine leichtere Montierbarkeit gegeben ist. So ist es möglich, dass in einem ersten Schritt die Anschluss- und Messvorrichtung mit der Leiterplatte gefertigt wird oder mit dieser verbunden wird. In einem zweiten Schritt, welcher nicht nur örtlich sondern auch zeitlich von dem ersten Schritt deutlich separiert sein kann, kann die Sensorvorrichtung an der Anschluss- und Messvorrichtung angebracht werden. So ist es möglich, dass die Leiterplatten separat von der Sensorvorrichtung gelagert und vertrieben, bzw. geliefert werden können. Auch der Einbau der Leiterplatten in komplexe Systeme ist deutlich einfacher möglich, da keine Kabel den Einbau stören. Befindet sich die Leiterplatte am gewünschten Ort, kann anschließend die separate Sensorvorrichtung über die Anschluss- und Messvorrichtung geschoben werden und sobald sie ihren Einsatzort erreicht hat, die Anschlussarbeiten mit der Stromversorgungsleitung durchgeführt werden. Darüber hinaus ist es auf diese Weise auch möglich, bestehende Systeme, die bereits ein sockelförmiges Kopplungsteil aufweisen, mit einer erfindungsgemäßen Sensorvorrichtung nachzurüsten.

Im Rahmen der vorliegenden Erfindung ist es auch möglich, dass vorteilhafterweise die Sensorvorrichtung der Anschluss- und Messvorrichtung eine elektrisch isolierende Beschichtung aufweist, die zumindest die Kontaktbereiche zwischen dem Magnetflussmedium der Sensorvorrichtung und dem sockelförmigen Kopplungsteil elektrisch voneinander isoliert. Damit ist nicht zwingend erforderlich, jedoch möglich, dass das Magnetflussmedium eine elektrisch isolierende Beschichtung aufweist, die diesen vollständig umgibt. Es ist zumindest vorteilhaft, wenn die elektrisch isolierende Beschichtung auf der Innenseite des Magnetflussmediums angebracht ist, so dass an den Stellen, an welchen das Magnetflussmedium in Kontakt mit dem sockelförmigen Kopplungsteil kommt, eine elektrische Isolierung stattfindet. Dies ist insbesondere dann sinnvoll, wenn es sich bei dem sockelförmigen Kopplungsteil um eine relativ einfache Ausführungsform handelt, welche keinerlei elektrische Isolierung nach außen aufweist. Somit kann die Komplexität der elektrischen Isolierung in das Sensorteil ausgelagert werden, so dass das sockelförmige Kopplungsteil nicht nur einfacher sondern auch kostengünstiger herstellbar ist. Die elektrische Isolierung dient, wie weiter oben bereits erläutert, auch an dieser Stelle dazu, die Kopplung zwischen der Sensorvorrichtung, insbesondere dem Magnetflussmedium, und dem sockelförmigen Kopplungsteil, insbesondere der elektrischen Verbindung, auf eine induktive Kopplung zu beschränken. Auf diese Weise wird die Genauigkeit der Messung der Anschluss- und Messvorrichtung erhöht.

Die Erzeugung der elektrisch isolierenden Beschichtung kann dabei auf unterschiedliche Weise erfolgen. So ist es möglich, dass Kunststoffbeschichtungen verwendet werden, welche das Magnetflussmedium umgeben. Diese können beispielsweise durch Aufkleben an den notwendigen Bereichen angebracht werden. Auch ein vollständiges Eingießen, bzw. ein Umspritzen des Magnetflussmediums mit Kunststoffmaterial ist denkbar. Hier sind alle üblichen Kunststoffverarbeitungsverfahren möglich, insbesondere im Bezug auf die Verwendung von thermoplastischen Materialien, welche in einem fließfähigen Zustand um das Magnetflussmedium herum geformt, bzw. gespritzt werden.

Auch kann es von Vorteil sein, wenn die Sensorvorrichtung einer erfindungsgemäße Anschluss- und Messvorrichtung eine dem sockelförmigen Kopplungsteil zugewandte Innenkontur aufweist, die zumindest abschnittsweise mit der Außenkontur des sockelförmigen Kopplungsteils korrespondiert. Unter dem Begriff "korrespondieren" ist damit im Idealfall ein Formschluss, also eine Positiv-Negativ-Form zu verstehen. Jedoch ist unter dem Begriff "korrespondieren" auch eine teilweise Korrespondenz zu verstehen, also ein teilweiser Formschluss bzw. Teilbereiche der Innenkontur der Sensorvorrichtung sowie Teilbereiche der Außenkontur des sockelförmigen Kopplungsteils, welche miteinander korrespondieren, zu verstehen. Die Korrespondenz dieser beiden Konturen hat den Vorteil, dass das Bauvolumen der gesamten Anschluss- und Messvorrichtung noch weiter minimiert werden kann. So ist es auf diese Weise möglich, Leervolumina, welche sonst zwischen der Sensorvorrichtung und dem sockelförmigen Kopplungsteil entstehen würden, zu reduzieren. Das benötigte Volumen für die Sensorvorrichtung, welches insbesondere durch die Bauhöhe des Hall-Elements und die notwendige Größe des Magnetflussmediums in Grundzügen vorgegeben ist, kann damit insbesondere in Bezug auf den Umfang um das sockelförmige Kopplungsteil herum auf ein Minimum reduziert werden. Die Reduktion des Baumaßes ermöglicht wiederum einen flexibleren Einsatz von Leiterplatten, welche mit einer erfindungsgemäßen Anschluss- und Messvorrichtung ausgestattet sind.

Neben der Möglichkeit, dass das sockelförmige Kopplungsteil einer erfindungsgemäßen Anschluss- und Messvorrichtung integral mit der Leiterplatte ausgestaltet ist, kann es von Vorteil sein, wenn das sockelförmige Kopplungsteil im Leiterplatten-Anschlussabschnitt mit Kontaktierelementen zum Kontaktieren der Leiterplatte versehen ist. Solche Kontaktierelemente können dabei in unterschiedlichster Weise ausgestaltet sein. So ist es möglich, dass die Kontaktierelemente Nasen oder Vorsprünge aufweisen, welche vorteilhafterweise mit korrespondierenden Vertiefungen auf einer Leiterplatte zusammenwirken können. Wird ein derartig ausgestaltetes sockelförmiges Kopplungsteil auf eine Leiterplatte aufgesetzt, so kann es über diese Nasen bzw. Vorsprünge mit der Leiterplatte verpresst werden. Durch das Verpressen entsteht ein Formschluss bzw. sogar ein Materialschluss zwischen Leiterplatte und sockelförmigem Kopplungsteil. Dieser Formschluss hat neben der mechanischen Fixierung des sockelförmigen Kopplungsteils an der Leiterplatte die Aufgabe, die elektrische Kontaktierung der Anschluss- und Messvorrichtung mit der Leiterplatte sicherzustellen. Auf diese Weise erzeugen die Kontaktierelemente eine doppelte Kontaktierfunktion, nämlich im elektrischen, wie auch im mechanischen Sinn.

Weiter ist es möglich, dass die Kontaktierelemente Gewindeführungen aufweisen, wobei sowohl Innen-, wie auch Außengewinde möglich sind. In der Leiterplatte sind vorteilhafterweise korrespondierende Außen-, bzw. Innengewinde vorgesehen, so dass die Anschluss- und Messvorrichtung, insbesondere das sockelförmige Kopplungsteil in die Leiterplatte eingeschraubt werden kann. Auch reversible oder irreversibel Schnapp-Rastverbindungen zwischen sockelförmigem Kopplungsteil und Leiterplatte sind im Rahmen der vorliegenden Erfindung denkbar.

Je nach gewünschter Flexibilität der Anschluss- und Messvorrichtung ist dabei bereits bei der Ausbildung der Kontaktierelemente eine irreversibel oder eine reversible Ausführungsform bevorzugbar. Die reversible Ausführungsform hat den Vorteil, dass eine höhere Flexibilität der Leiterplatte erzeugt werden kann. So ist es möglich, bei Defekten auf der Leiterplatte diese auszutauschen und die Anschluss- und Messvorrichtung als separates Element von der Leiterplatte zu trennen und mit einer neuen, funktionstüchtigen Leiterplatte weiter zu verwenden. Neben der Kosteneinsparung durch eine solche Funktionsweise kann auch ein nachhaltigeres Wirtschaften erzielt werden, da elektronischer Müll vermieden wird.

In schwer zugänglichen Bereichen, bzw. bei Einsatzsituationen, welche durch Erschütterungen oder Vibrationen stark beeinträchtigt sein können, kann es vorteilhaft sein, wenn die Verbindung zwischen der Anschluss- und Messvorrichtung, insbesondere dem sockelförmigen Kopplungsteil, und der Leiterplatte irreversibl erfolgt. Auf diese Weise kann die Standfestigkeit der elektrischen Verbindung, wie auch der mechanischen Verbindung zwischen sockelförmigem Kopplungsteil und der Leiterplatte erhöht werden. Insbesondere wird vermieden, dass sich die Verbindung der beiden Elemente versehentlich, also ungewollt, voneinander trennt.

Ein weiterer Vorteil kann es sein, wenn die Sensorvorrichtung einer erfindungsgemäßen Anschluss- und Messvorrichtung eine Sicherungsvorrichtung aufweist, welche die Sensorvorrichtung an dem sockelförmigem Kopplungsteil befestigt. Eine solche Sicherungsvorrichtung ist insbesondere dann sinnvoll, wenn es sich bei der Sensorvorrichtung um ein von dem sockelförmigen Kopplungsteil separates Bauteil handelt. So kann es sich im Rahmen der vorliegenden Erfindung um eine Sensorvorrichtung handeln, die ausschließlich um das sockelförmige Kopplungsteil herum gelegt ist. Ohne das Vorsehen einer Sicherungsvorrichtung würde die Sensorvorrichtung demnach nicht zwingend an dem vordefinierten Ort verbleiben. So wäre es möglich, dass sich die Sensorvorrichtung von diesem Ort entfernt und damit Fehlmessungen entstehen, die zu einer Fehlfunktion der Leiterplatte oder sogar zur Zerstörung der Leiterplatte führen könnte.

Eine solche Sicherungsvorrichtung kann ebenfalls reversibel oder irreversibel ausgeführt sein und dient neben der Sicherung der örtlichen Anordnung der Sensorvorrichtung auch als Verlustsicherung für diese. Die Sicherungsvorrichtung kann dabei mit anderen Arbeitsschritten bei der Montage einer Leiterplatte verbunden werden. So ist es zum Beispiel möglich, dass die Sicherungsvorrichtung beim Verbinden des sockelförmigen Kopplungsteils mit der Leiterplatte zwischen dem sockelförmigen Kopplungsteil und der Leiterplatte zu liegen kommt. Durch das Verbinden der beiden Bauteile wird die Sicherungsvorrichtung zwischen diesen beiden Bauteilen eingeklemmt und verhindert, dass die Sensorvorrichtung sich von dem vordefinierten Ort entfernt. Auch reversible Sicherungen durch Schnapp-Rastverbindungen oder Gewindeverbindungen sind selbstverständlich im Rahmen der vorliegenden Erfindung denkbar. Auch ist es möglich, dass eine Verbindung mit einer axialen Nase und einer axialen Nut, also einer Nase und einer Nut, welche im wesentlichen senkrecht zur Umfangsrichtung der Sensorvorrichtung bzw. des sockelförmigen Kopplungsteils verlaufen, als Sicherungsvorrichtung verwendet werden. Eine Korrespondenz zwischen Axialnut und Axialnase ist insbesondere durch einen Anstellwinkel der jeweiligen Nut bzw. der Nase verbessert, welcher im selbsthemmenden Bereich liegt. Auf diese Weise wird das Zusammenstecken der Sensorvorrichtung und des sockelförmigen Kopplungsteils gleichzeitig zum Sichern der Sensorvorrichtung am sockelförmigen Kopplungsteil verwendet.

Auch ist es möglich, dass bei einer erfindungsgemäßen Anschluss- und Messvorrichtung die Sensorvorrichtung als mechanische Sicherheitsvorrichtung zumindest einen Lagerungsabsatz oder Zwischenabsatz oder Befestigungsabsatz aufweist, der derart gestaltet ist, dass auf eine erste Anlageseite desselben das Kopplungsteil aufsetzbar ist und dass eine zweite, zur ersten Anlageseite entgegen gesetzt gerichtet zweite Anlageseite auf die Leiterplatte insbesondere flächig oder formschlüssig aufsetzbar ist, so dass wenigstens ein Abschnitt des Befestigungsabsatzes beim elektrischen Kontaktieren des sockelförmigen Kopplungsteils mit der Leiterplatte mittels Kontaktierelementen zwischen dem sockelförmigen Kopplungsteil und der Leiterplatte gelegen ist und durch das Kontaktieren des sockelförmigen Kopplungsteils mit der Leiterplatte die Sensorvorrichtung relativ zum sockelförmigen Kopplungsteil örtlich und/oder in ihrer Lage festgelegt wird. Bei dem Aufsetzen des Kopplungsteils mit der Sensorvorrichtung auf der Leiterplatte und beim Kontaktieren des sockelförmigen Kopplungsteils mit der Leiterplatte befindet sich der zwischen dem sockelförmigen Kopplungsteil und der Leiterplatte. Insbesondere kann dabei die Außenwandung des Kopplungsteils und kann die dieser zugewandten Innenwandung der Sensorvorrichtung derart gestaltet sein, dass diese formschlüssig inenander greifen, wenn das Kopplungsteil auf dem Zwischenabsatz aufliegt. Dies ist insbesondere der Fall, wenn die Kontaktelement in entsprechende Aufnahmen von der Leitplatte eingeführt sind, um das Kopplungsteil elektrisch mit der Leiterplatte und insbesondere einem Stromversorgungsmodul zur Versorung von elektrischen und/oder eletronischen Komponenten auf der Leitplatte mit Energie zu versorgen. In diesem Zustand wird also die Sensorvorrichtung in ihrer Lage und insbesondere ihrer Orientierung in Bezug auf ihre Umfangsrichtung durch das Kontaktieren des sockelförmigen Kopplungsteils mit der Leiterplatte relativ zum sockelförmigen Kopplungsteil festgelegt. Mit anderen Worten ist bei einer derartigen Ausgestaltung die Sicherungsvorrichtung selbst Teil der Sensorvorrichtung, da die Sensorvorrichtung die Sicherungsfunktion zur Sicherung und Fixierung der Lage der Sensorvorrichtung auf der und relativ zu der Leiterplattte übernimmt, wenn die Kontaktelemente der Kopplungsvorrichtung in die Kontaktaufnahmen der Leiterplatte eingeführt oder eingesteckt sind. Dies kann durch integrale Ausgestaltung oder durch reversibel oder irreversibel Verbindung zwischen einzelnen Komponenten in der Sensorvorrichtung und der Sicherungsvorrichtung erzielt werden. Durch die örtliche Definition der Sicherungsvorrichtung als Befestigungsabsatz wird bei dem Verpressen des sockelförmigen Kopplungsteils in der Leiterplatte der Befestigungsabsatz mit verpresst, so dass auch hier ein Form-, wenn nicht sogar ein Material-Schluss entsteht, der als Sicherung der Sensorvorrichtung am vordefinierten Ort dient.

Auch kann es vorteilhaft sein, wenn die Sensorvorrichtung einer erfindungsgemäßen Anschluss- und Messvorrichtung eine stromdurchflossene Spule aufweist, welche um das Magnetflussmedium der Sensorvorrichtung gewickelt ist. Eine solche Ausgestaltungsform ist unter dem Grundbegriff "Closed Loop-Messung" eines Hall-Sensors bekannt. Diese Wicklung ist gemäß der "Closed Loop-Funktionalität" in die Messsystematik, eingebunden, insbesondere mit der Messsignalleitung des Hall-Sensors gekoppelt. Auf diese Weise ist es möglich, dass durch Kompensation unerwünschter Effekte die Sensibilität des Hall-Sensors und damit die Genauigkeit der Sensorvorrichtung hinsichtlich der Messung der Stromversorgung, also des elektrischen Stroms der Stromversorgungsleitung verbessert wird. Weiter ist es auf diese Weise möglich, dass sowohl eine Stromversorgung mit Gleichstrom, wie auch eine Stromversorgung mit Wechselstrom durch ein und dieselbe Sensorvorrichtung überwacht werden kann.

Ein weiterer Gegenstand der vorliegenden Erfindung ist eine Leiterplatte, aufweisend elektrische Leiterbahnen sowie eine Anschluss- und Messvorrichtung für den Anschluss einer Stromversorgung an die Leiterplatte. Die Anschluss- und Messvorrichtung für den Anschluss einer Stromversorgung weist dabei ein sockelförmiges Kopplungsteil und eine Sensorvorrichtung auf. Das sockelförmige Kopplungsteil ist mit einem an einem ersten Sockelende ausgebildeten Leitungs-Anschlussabschnitt für den Anschluss der Stromversorgungsleitung und mit einem am zweiten Sockelende ausgebildeten Leiterplatten-Anschlussabschnitt für den Kontakt mit der Leiterplatte versehen. Dazwischen erstreckt sich eine elektrische Verbindung zur elektrischen Kopplung des Leitungs-Anschlussabschnitts mit dem Leiterplatten-Anschlussabschnitt. Die Sensorvorrichtung weist ein Magnetflussmedium auf, der um die elektrische Verbindung umlaufend vorgesehen ist und eine Ausnehmung aufweist. In der Ausnehmung ist ein Hall-Sensor angeordnet, der einen Anschluss zu einer elektrischen Messsignalleitung aufweist, so dass in Abhängigkeit des im Magnetflussmedium induzierten Magnetfelds ein elektrisches Signal erzeugt wird. Die Vorteile sowie die vorteilhaften Ausführungsformen einer derartigen Leiterplatte ergeben sich durch die Verwendung einer erfindungsgemäßen Anschluss- und Messvorrichtung wie voranstehend ausführlich erläutert.

Bei einer erfindungsgemäßen Leiterplatte kann es weiter vorteilhaft sein, wenn eine Stromversorgungsleitung vorgesehen ist, welche in elektrisch kommunizierender Weise mit dem Leitungs-Anschlussabschnitt des sockelförmigen Kopplungsteils verbunden ist. Diese Stromversorgungsleitung kann zum Beispiel durch ein Überstülpen der Stromversorgungsleitung, insbesondere einer daran vorgesehenen Nut oder Öse, über das sockelförmige Kopplungsteil der Anschluss- und Messvorrichtung ausgestaltet sein. Eine Fixierung kann durch eine Sicherungsvorrichtung erfolgen. Diese Sicherungsvorrichtung kann vorteilhafterweise integral mit der Sicherungsvorrichtung der Sensorvorrichtung ausgebildet sein. So ist es auch möglich, dass eine Verschraubung, eine Vernietung oder andere reversible oder irreversible mechanische Mittel vorgesehen sind, welche die Stromversorgungsleitung am vordefinierten Ort halten.

Ein weiterer Gegenstand der vorliegenden Erfindung ist eine Sensorvorrichtung, welche zumindest ein Magnetflussmedium mit einer ringförmigen Ausbildung aufweist, und die derart ausgestaltet ist, dass bei Stromfluss durch ein elektrisch leitendes Material, welches sich durch das Innere der ringförmigen Ausbildung des Magnetflussmediums erstreckt, ein Magnetfeld im Magnetflussmedium induziert wird. Weiter ist ein Hall-Sensor vorgesehen, welcher derart angeordnet ist, dass er in Abhängigkeit von der Feldstärke des vom Magnetflussmedium induzierten Magnetfelds ein elektrisches Signal erzeugt. Vorteilhafterweise ist eine solche Sensorvorrichtung derart ausgestaltet, wie sie im Rahmen der erfindungsgemäßen Anschluss- und Messvorrichtung bereits oben ausführlich erläutert worden ist. Eine erfindungsgemäße Sensorvorrichtung weist dementsprechend die gleichen Vorteile wie diese auf.

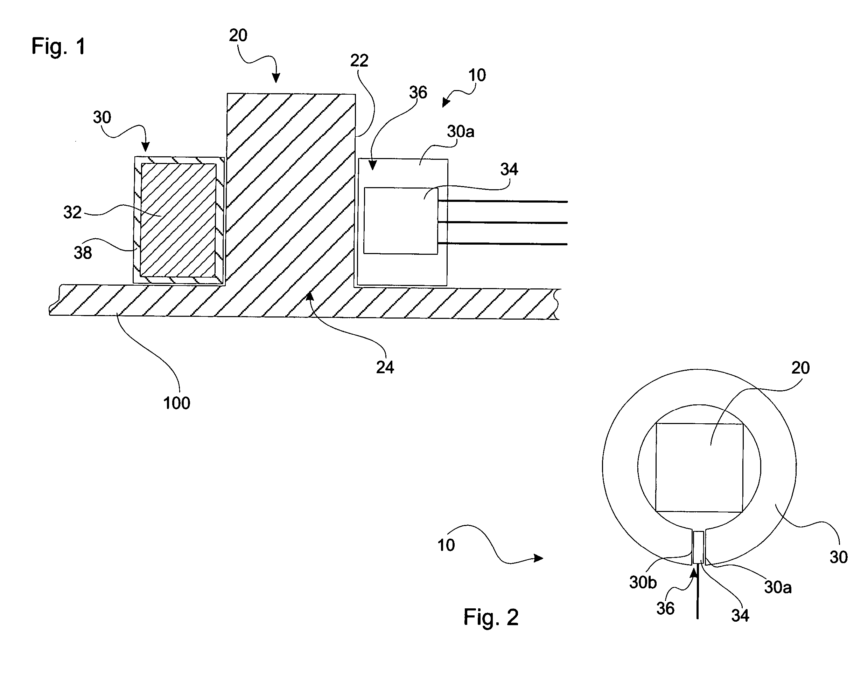

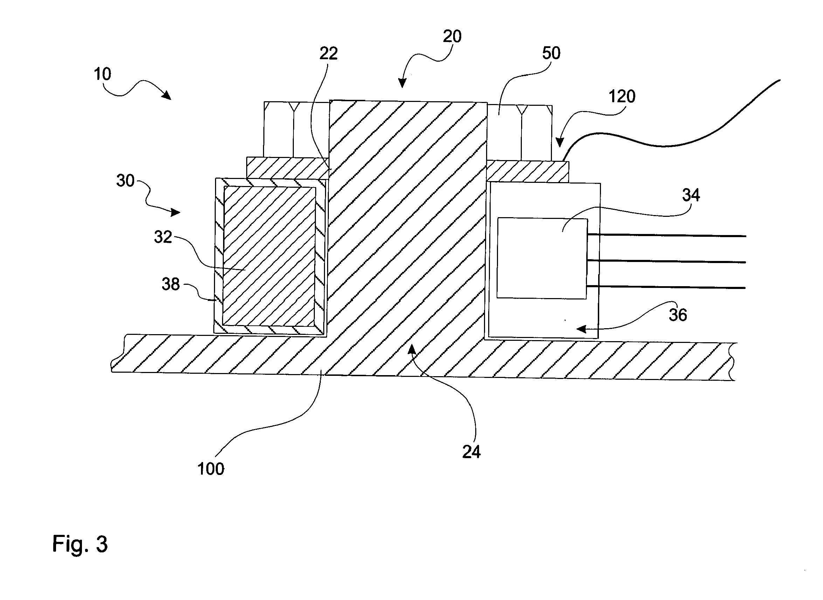

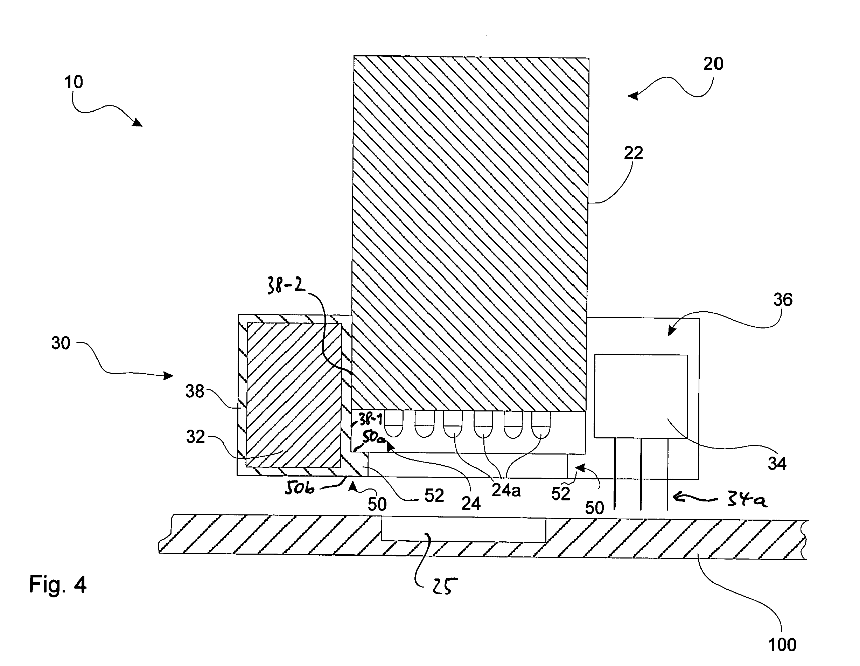

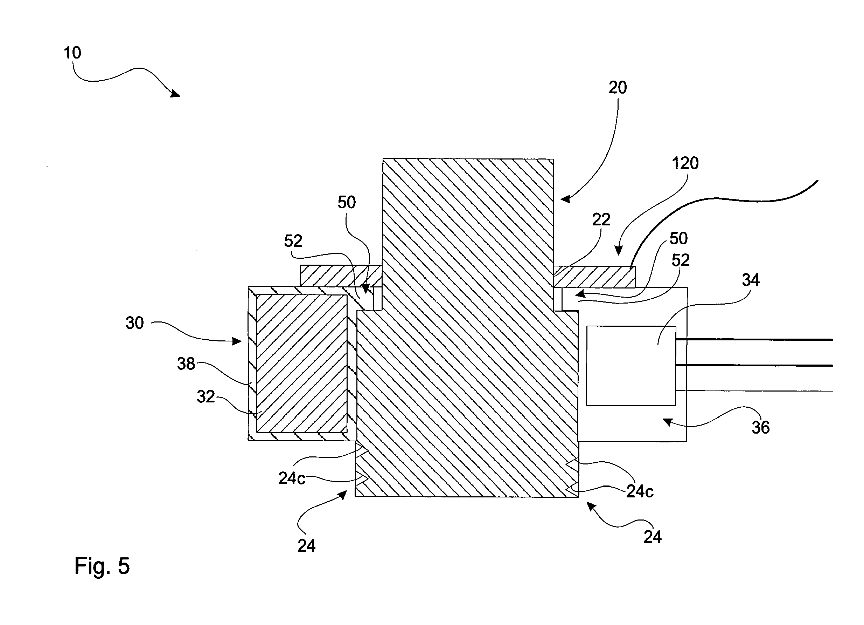

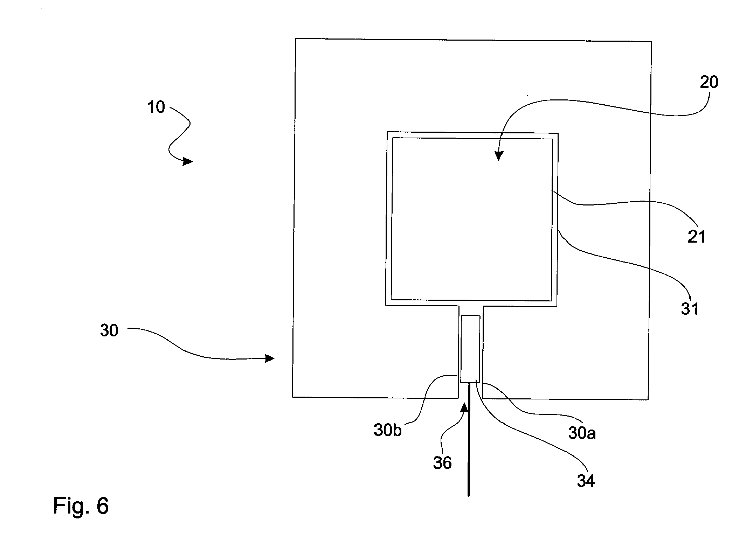

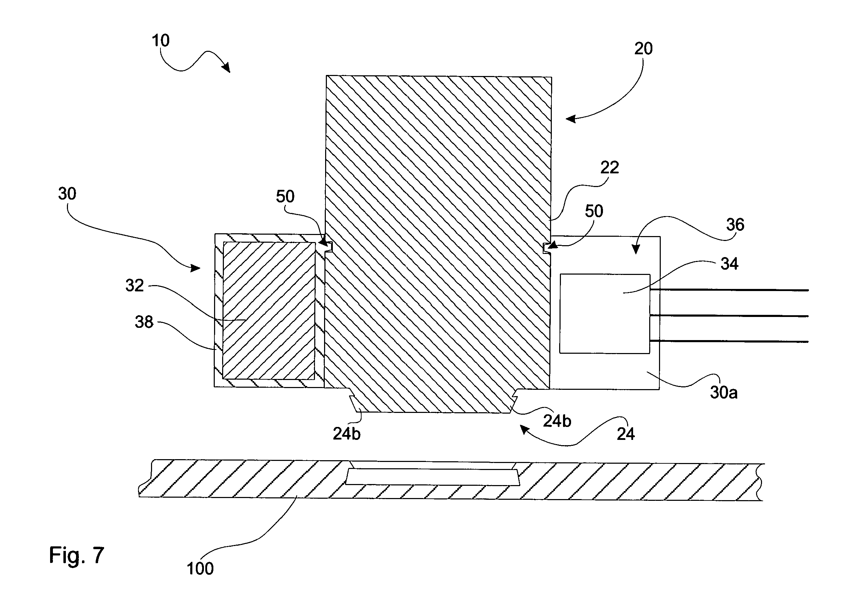

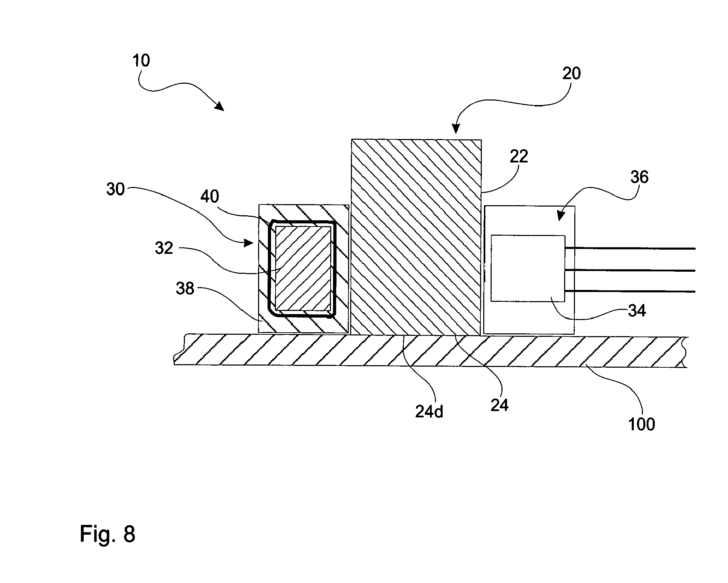

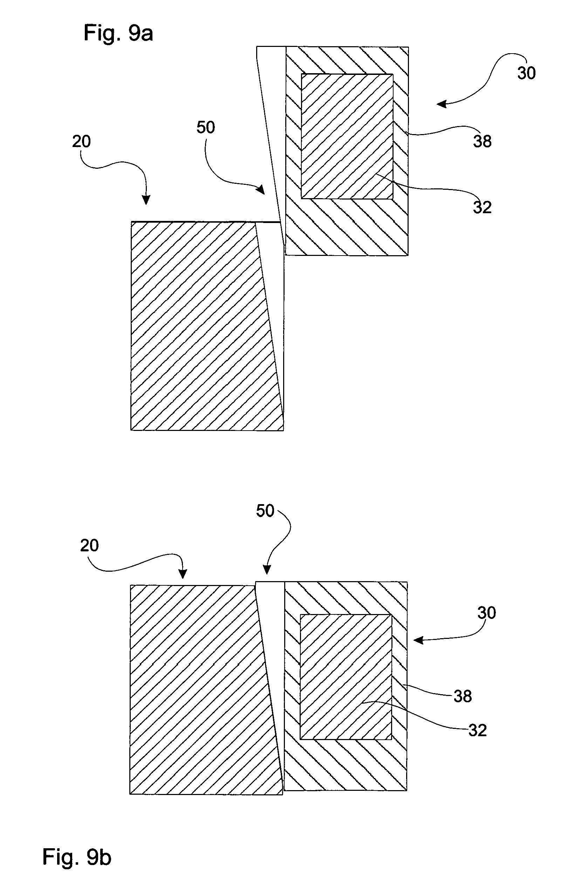

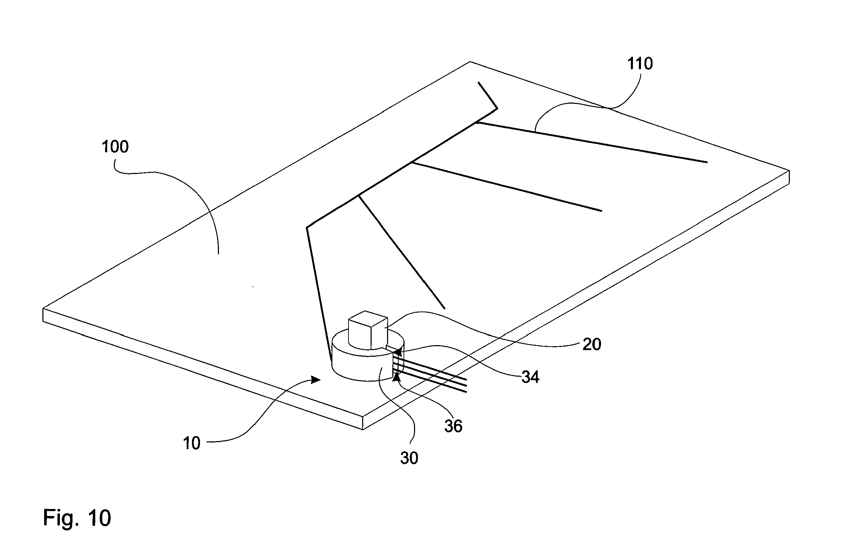

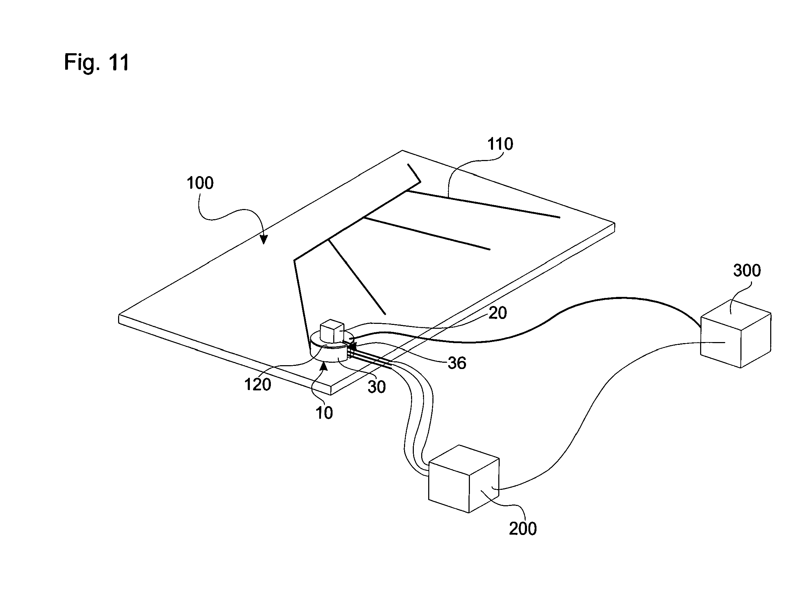

Die Erfindung wird näher erläutert anhand der beigefügten Zeichnungsfiguren. Bei der Beschreibung der Zeichnungsfiguren beziehen sich die Begriffe "links", "rechts", "oben" und "unten" auf eine Ausrichtung der Zeichnungsfiguren mit normal lesbaren Bezugszeichen. Es zeigen:
■ Fig. 1 im Querschnitt eine erste Ausführungsform einer Anschluss- und Messvorrichtung.
■ Fig. 2 in der Draufsicht einer erfindungsgemäßen Anschluss- und Messvorrichtung gemäß der Ausführungsform der Fig. 1
■ Fig. 3 im Querschnitt die Anschluss- und Messvorrichtung der Fig. 1 und 2 mit gesicherter und angeschlossener Stromversorgungsleitung.
■ Fig. 4 im Querschnitt eine Explosionsdarstellung einer weiteren Ausführungsform einer Anschluss- und Messvorrichtung.
■ Fig. 5 ein Querschnitt eine weitere Ausführungsform einer erfindungsgemäßen Anschluss- und Messvorrichtung.
■ Fig. 6 in der Draufsicht eine weitere Ausführungsform einer erfindungsgemäßen Anschluss- und Messvorrichtung.
■ Fig. 7 im Querschnitt eine weitere Ausführungsform einer erfindungsgemäßen Anschluss- und Messvorrichtung während des Zusammenbauvorgangs.
■ Fig. 8 im Querschnitt eine weitere Ausführungsform einer erfindungsgemäßen Anschluss- und Messvorrichtung.
■ Fig. 9A im Querschnitt ein Ausschnitt einer Sicherungsvorrichtung einer weiteren Ausführungsform einer erfindungsgemäßen Anschluss- und Messvorrichtung.
■ Fig. 9B im Querschnitt der Ausschnitt gemäß Fig. 9A mit zusammengebauter Sicherungsvorrichtung.
■ Fig. 10 in isometrischer Darstellung eine erfindungsgemäße Leiterplatte einer ersten Ausführungsform.
■ Fig. 11 in isometrischer Darstellung eine weitere Ausführungsform einer erfindungsgemäßen Leiterplatte.

Fig. 1 zeigt im Querschnitt eine erste Ausführungsform einer Anschluss- und Messvorrichtung 10. Die Anschluss- und Messvorrichtung 10 in Fig. 1 ist im Querschnitt dargestellt und noch nicht mit einer Stromversorgungsleitung 120 versehen. Die Anschluss- und Messvorrichtung 10 gemäß der Ausführungsform in Fig. 1 weist ein sockelförmiges Kopplungsteil 20 auf, welches integral mit einer Leiterplatte 100 ausgebildet ist. Die beiden Elemente sind einstückig ausgeformt, so dass eine Verbindung der beiden Elemente nicht erfolgen muss. Um das sockelförmige Kopplungsteil 20 herum ist eine Sensorvorrichtung 30 gelegt. Die Sensorvorrichtung 30 weist dabei in seiner Korrelation eine Ausbildung auf, wie sie in der Draufsicht der Fig. 2 zu entnehmen ist. Die Sensorvorrichtung 30 umschließt das sockelförmige Kopplungsteil 20. Dabei ist dieses Umschließen noch nicht als Formschluss zu verstehen, da es sich bei dem sockelförmigen Kopplungsteil 20 um ein Bauteil mit rechteckigem Querschnitt handelt, während die Sensorvorrichtung 30 im wesentlichen ringförmig mit einer runden Ringform ausgestaltet ist.

Die Sensorvorrichtung 30 umläuft das sockelförmige Kopplungsteil 20 nicht vollständig, sondern weist eine Ausnehmung 36 in Form eines durchgehenden Schlitzes auf. In dieser Ausnehmung 36 ist ein Hall-Sensor 34 angeordnet. Der Hall-Sensor 34 steht dabei derart in der Ausnehmung 36, dass die beiden Hauptflächen des Hall-Sensors 34 im Wesentlichen parallel zu den beiden Enden 30a und 30b in der Ausnehmung 36 des Magnetflussmediums 32 der Sensorvorrichtung 30 liegen. Weiter weist der Hall-Sensor 34 drei Anschlussleitungen auf, welche dazu dienen, die vom Hall-Sensor 34 erzeugten Messsignale zu einer in den in Fig. 1 und 2 nicht dargestellten Auswerteeinrichtung zu leiten. Hierfür könne die Anschlüsse des Hall-Sensors 34 mit nicht dargestellten Messsignalleitungen verbunden werden, welche nicht nur die Messkommunikation, sondern vorteilhafterweise auch die Stromversorgung des Hall-Sensors selbst übernehmen.

Um sicherzustellen, dass bei der Ausführungsform gemäß den Fig. 1 und 2 kein elektrischer Kontakt zwischen dem Magnetflussmedium 32 der Sensorvorrichtung 30 einerseits und dem sockelförmigen Kopplungsteil 20 andererseits entstehen, ist das Magnetflussmedium 32 wenigstens abschnittsweise mit einer Ummantelung 38, die insbesondere ein Gehäuse, eine Wandung oder eine Beschichtung sein kann, versehen. Diese Ummantelung 38 und insbesondere Beschichtung ist aus einem elektrisch isolierenden Material, beispielsweise aus einem Kunststoff, insbesondere einem thermoplastischen Kunststoff ausgeführt. Bei der Ausführungsform gemäß den Fig. 1 und 2 ist die elektrisch isolierende Beschichtung 38 vollständig um das Magnetflussmedium 32 der Sensorvorrichtung 30 herum ausgeführt. Damit schützt diese Beschichtung 38 das Magnetflussmedium nicht nur vor elektrischem Kontakt mit dem sockelförmigen Kopplungsteil 20, sondern auch mit potentiell um die Anschluss-und Messvorrichtung 10 herum befindlichen anderen Elementen. Nach einem anderen Ausführungsbeispiel ist die Ummantelung 38 nur in dem Bereich zwischen den Oberflächenabschnitten des Sensors, also Magnetflussmediums 32 der Sensorvorrichtung 30, und des Kopplungsteils 20, die einander zugewandt sind, gelegen, wenigstens soweit diese sich entlang zueinander erstrecken, jedcoh nicht notwenigerweise an anderen Oberflächenabschnitten des Sensors, so dass kein Strom zwischen dem Sensor und ddem Kopplungsteil 20 fleißen kann.

In Fig. 3 ist die Anschluss- und Messvorrichtung 10 der Fig. 1 und 2 im Querschnitt nochmals dargestellt, jedoch hier in einer Ausführungsform, wie sie im Einsatz einer erfindungsgemäßen Anschluss- und Messvorrichtung 10 anzutreffen ist. So ist hier eine Stromversorgungsleitung 120 vorgesehen, welche in Kontakt mit dem sockelförmigen Kopplungsteil 20 tritt. Hier sind, wie bereits in Fig. 1 zu erkennen, die beiden Anschlussabschnitte des sockelförmigen Kopplungsteils 20 zu beachten. So ist am oberen Ende des sockelförmigen Kopplungsabschnitts 20 ein Leitungs-Anschlussabschnitt 22 vorgesehen, an welchem die Stromversorgungsleitung 120 angeordnet ist. Die Anordnung der Stromversorgungsleitung 120 erfolgt dabei über einen reinen Kontakt der Oberflächen der Stromversorgungsleitung 120 einerseits und des Leitungs-Anschlussabschnitts 22 des sockelförmigen Kopplungsteils 20 andererseits. Hierfür weist die Stromversorgungsleitung 120 eine Vorrichtung, zum Beispiel in Form einer Öse, auf, welche über das sockelförmige Kopplungsteil 20 gestülpt werden kann, und derart ausgestaltet ist, dass sie in Kontakt mit der Oberflächen des sockelförmigen Kopplungsteils im Bereich des Leitungs-Anschlussabschnitts 22 treten kann. Auf diese Weise ist eine elektrische Verbindung zwischen der Stromversorgungsleitung 120 und dem sockelförmigen Kopplungsteil 20 hergestellt.

Am anderen Ende des sockelförmigen Kopplungsteils 20, also am unteren Sockelende, befindet sich der Leiterplatten-Anschlussabschnitt 24. Dieser ist aufgrund der integralen Ausgestaltung der Anschluss- und Messvorrichtung 10 der vorliegenden Ausführungsform mit der Leiterplatte 100 strukturell als materialische Einstückigkeit mit der Leiterplatte 100 zu erkennen. So ist auf diese Weise nicht nur die mechanische Sicherung des sockelförmigen Kopplungsteils 20 an der Leiterplatte 100, sondern auch die elektrisch leitfähige Verbindung zwischen dem sockelförmigen Kopplungsteil 20 und der Leiterplatte 100 gegeben.

Anhand der Fig. 1 bis 3 soll nachfolgend kurz die Funktionsweise einer erfindungsgemäßen Anschluss- und Messvorrichtung 10 erläutert werden.

Ist eine Leiterplatte 100 mit einem sockelförmigen Kopplungsteil 20 gemäß der vorliegenden Erfindung versehen, so kann eine Sensorvorrichtung 30 über das sockelförmige Kopplungsteil 20 geschoben werden, wie dies in Fig. 1 im Endzustand gezeigt ist. Dabei ist im ersten Schritt unerheblich, ob eine Konturanpassung der Sensorvorrichtung 30 an das sockelförmige Kopplungsteil 20 erfolgt oder, wie in Fig. 2 dargestellt, nicht. Anschließend wird die Stromversorgung der Leiterplatte 100 dadurch hergestellt, dass eine Stromversorgungsleitung 120 auf die Anschluss- und Messvorrichtung 10, insbesondere das obere Ende des sockelförmigen Kopplungsteils 20 aufgesetzt wird. Dabei tritt die Stromversorgungsleitung 120 mit dem Leitungs-Anschlussabschnitt 22 des sockelförmigen Kopplungsteils 20 in Kontakt. Dies ist ein elektrischer Kontakt, welcher die Leitung von elektrischem Strom von der Stromversorgungsleitung 120 in das sockelförmige Kopplungsteil 20 hinein ermöglicht. Durch die integrale Ausgestaltung der Ausführungsform der Fig. 1 bis 3 der Leiterplatte 100 und des sockelförmigen Kopplungsteils 20 ist am unteren Sockelende des sockelförmigen Kopplungsteils 20 auch eine elektrische und mechanische Verbindung zwischen dem sockelförmigen Kopplungsteil 20 und der Leiterplatte 100 gegeben. Damit ist die elektrische Verbindung der Leiterplatte 100 zur Stromversorgungsleitung 120 sichergestellt. Strom kann nun über die Stromversorgungsleitung 120 durch das sockelförmige Kopplungsteil 20 in die Leiterplatte 100 einströmen.

Der Strom in dem sockelförmigen Kopplungsteil 20, insbesondere der elektrischen Verbindung zwischen dem Leitungs-Anschlussabschnitt 22 und dem Leiterplatten-Anschlussabschnitt 24, erzeugt dabei aufgrund physikalischer Gegebenheiten ein Magnetfeld um den Leiter des sockelförmigen Kopplungsteils 20 herum. Dieses Magnetfeld wiederum beeinflusst das Magnetfeld des Magnetfelderzeugers 32 der Sensorvorrichtung 30. Diese Beeinflussung erzeugt insbesondere eine Schwankung des Magnetfelderzeugers 32 hinsichtlich der Stärke des darin induzierten Magnetfelds. So ist mit anderen Worten die Stärke des Magnetfelds im Magnetfelderzeuger 32 der Sensorvorrichtung 30 abhängig von der Stromstärke, welche zwischen Stromversorgungsleitung 120 und Leiterplatte 100 durch das sockelförmige Kopplungsteil 20 fließt.

Der Hall-Sensor 34 ist in einer schlitzförmigen Ausnehmung 36 zwischen zwei Enden 30a und 30b des Magnetflussmediums 32 angeordnet. An dieser Stelle kann er in Abhängigkeit des im Magnetflussmedium 32 erzeugten Magnetfelds ein entsprechendes Signal, insbesondere in Form eines variierenden Stromflusses abgeben. Dabei ist der Hall-Sensor 34 in der Lage, direkt die induzierten Magnetfeldschwankungen im Magnetflussmedium 32 zu messen und damit indirekt den Strom bzw. die Schwankungen des Stroms, der von der Stromversorgungsleitung 120 über die elektrische Verbindung zwischen dem Leiter-Anschlussabschnitt 22 und dem Leiterplatten-Anschlussabschnitt 24 des sockelförmigen Kopplungsteils 20 zu der Leiterplatte 100 fließt, zu messen.

Um sicherzustellen, dass das Gesamtsystem einer Anschluss- und Messvorrichtung 10 gemäß der Fig. 1 bis 3, also alle einzelnen Komponenten, in den definierten Positionen verbleibt, ist in Fig. 3 nach dem Anschluss der Stromversorgungsleitung 120 zusätzlich eine Sicherungsvorrichtung 50 in Form einer Überwurfmutter vorgesehen. Diese Überwurfmutter korrespondiert hinsichtlich des vorhandenen Innengewindes in der Überwurfmutter mit einem Außengewinde des sockelförmigen Kopplungsteils 20. Der Übersichtlichkeit halber sind beide Gewindeformen in den Figuren nicht dargestellt. Nach dem Überstülpen der Stromversorgungsleitung 120 wird die Sicherungsvorrichtung 50 in Form einer Überwurfmutter aufgeschraubt und das Gesamtsystem, also die Stromversorgungsleitung 120 zusammen mit der Sensorvorrichtung 30 zwischen der Sicherungsvorrichtung 50 einerseits und der Leiterplatte 100 andererseits verspannt und damit gesichert. Bei der Sicherungsvorrichtung 50 dieser Ausführungsform handelt es sich durch die Ausführung mittels einer Gewindeverbindung um eine reversible Verbindung. Das bedeutet, dass die Stromversorgungsleitung 120 auch wieder entfernt werden kann.

In Fig. 4 ist eine weitere Ausführungsform einer erfindungsgemäßen Anschluss- und Messvorrichtung 10 dargestellt. Im Querschnitt zeigt Fig. 4 insbesondere eine Ausführungsform, bei welcher das sockelförmige Kopplungsteil 20 nicht integral mit der Leiterplatte 100 ausgebildet ist. Vielmehr ist bei dem sockelförmigen Kopplungsteil 20 der Ausführungsform gemäß Fig. 4 eine Kopplung mit der Leiterplatte 100 über Kontaktierelemente 24a in Form von Nasen vorgesehen. In der Leiterplatte 100 ist eine Vertiefung vorgesehen, welche mit dem Bereich korrespondiert, in welchem die Kontaktierelemente 24a in Form von Nasen an dem sockelförmigen Kopplungsteil 20 angeordnet sind. Die Fig. 4 zeigt die Situation während der Montage der Anschluss-und Messvorrichtung 10, also noch vor dem Verbinden, insbesondere vor dem Verpressen.

Darüber hinaus ist eine Besonderheit der Ausführungsform gemäß Fig. 4, dass die Anschluss- und Messvorrichtung 10 über eine Sicherungsvorrichtung 50 verfügt, die eine insbesondere irreversible Sicherung der Sensorvorrichtung 30 hinsichtlich des Ortes erzielt. Diese ist gegeben über einen Befestigungsabsatz 52, welcher in Umfangsrichtung umlaufend am Innenbereich der Sensorvorrichtung 30 angeordnet ist. Im einfachsten Fall handelt es sich bei dem Befestigungsabsatz 52 um das gleiche Material wie bei der elektrisch isolierenden Beschichtung 38, so dass in einem Arbeitsgang die elektrisch isolierende Beschichtung 38 und der Befestigungsabsatz 52, beispielsweise durch Umspritzen mit einem thermoplastischen Material, um das Magnetflussmedium 32 herum hergestellt werden kann.

Die mechanische Sicherheitsvorrichtung weist zumindest einen Lagerungsabsatz 52 oder Zwischenabsatz oder Befestigungsabsatz aufweist, der insbesodnere als ringfömiger Abshcnitt 50c derart gestaltet ist, dass auf eine erste Anlageseite 50a desselben das Kopplungsteil 20 aufsetzbar ist und dass eine zweite, zur ersten Anlageseite 50a entgegen gesetzt gerichtete zweite Anlageseite 50b auf die Leiterplatte insbesondere flächig oder formschlüssig aufsetzbar ist. Bei letzterer Alternative ist die Oberseite der Leiterplatte zur Aufnahme des Kopplungsteils abschnittsweise mit einer Formschlussaufnahme insbesondere mit wenigstens einer Vertiefung und/oder Erhebung versehen, die zur formschlüssigen Aufnahme einer entsprechenden komplementär ausgebildeten Formschlussaufnahme der Senorvorrichtung oder einer Ummantelung 38 derselben ausgeführt ist. Dadurch wird erreicht, dass wenigstens ein Abschnitt des Befestigungsabsatzes 50 beim elektrischen Kontaktieren des sockelförmigen Kopplungsteils 20 mit der Leiterplatte mittels Kontaktierelementen zwischen dem sockelförmigen Kopplungsteil 20 und der Leiterplatte 100 gelegen ist und durch das Kontaktieren des sockelförmigen Kopplungsteils 20 mit der Leiterplatte 100 die Sensorvorrichtung 30 relativ zum sockelförmigen Kopplungsteil örtlich und/oder in ihrer Lage festgelegt wird. Die Sensorvorrichtung 30 kann dann nicht mehr reltiv zur Leiterplatte gedreht werden, solange diese von der Leiterplatte aúfgenommen ist. Auf die Ausführung mit formschlüssiger Aufnahme der Sensorvorrichtung 30 auf der Leiteplatte 100 kann insbesondere verzichtet werden, wenn die Kontaktieelement des Kopplungsteils 20 derart ausgeführt sein, dass diese das Kopplungsteil in iher Lage relativ zur Leiterplatte insbesondere in Drehrichtung relativ zu dieser festlegt und mechanisch ausreichend fest ist und sichern kann. Bei dem Aufsetzen des Kopplungsteils mit der Sensorvorrichtung auf der Leiterplatte und beim Kontaktieren des sockelförmigen Kopplungsteils mit der Leiterplatte befindet sich der Lagerungsabsatz 52 zwischen dem Kopplungsteil 20 und der Leiterplatte 100. Insbesondere kann dabei die Außenwandung des Kopplungsteils 38-2 und kann die dieser zugewandten Innenwandung 28-1 der Sensorvorrichtung 30 oder deren Ummantelung 38 derart gestaltet sein, dass diese formschlüssig ineinander greifen, wenn das Kopplungsteil 20 auf dem Zwischenabsatz 52 aufliegt. Dies ist insbesondere der Fall, wenn das wenigstens eine Kontaktelement in entsprechende Aufnahmen oder Kontaktaufnahmen 25 der Leitplatte eingeführt ist, um das Kopplungsteil elektrisch mit der Leiterplatte und insbesondere einem Stromversorgungsmodul zur Versorung von elektrischen und/oder eletronischen Komponenten auf der Leitplatte mit Energie zu versorgen. In diesem Zustand wird also die Sensorvorrichtung in ihrer Lage und insbesondere ihrer Orientierung in Bezug auf ihre Umfangsrichtung durch das Kontaktieren des sockelförmigen Kopplungsteils mit der Leiterplatte relativ zum sockelförmigen Kopplungsteil festgelegt. Mit anderen Worten ist bei einer derartigen Ausgestaltung die Sicherungsvorrichtung selbst Teil der Sensorvorrichtung, da die Sensorvorrichtung die Sicherungsfunktion zur Sicherung und Fixierung der Lage der Sensorvorrichtung auf der und relativ zu der Leiterplattte übernimmt, wenn die Kontaktelemente der Kopplungsvorrichtung in die Kontaktaufnahmen der Leiterplatte eingeführt oder eingesteckt sind. Dies kann durch integrale Ausgestaltung oder durch reversibel oder irreversibel Verbindung zwischen einzelnen Komponenten in der Sensorvorrichtung und der Sicherungsvorrichtung erzielt werden. Durch die örtliche Definition der Sicherungsvorrichtung als Befestigungsabsatz wird bei dem Verpressen des sockelförmigen Kopplungsteils in der Leiterplatte, wenn diese derart ausgeüfhrt sind, dass diese bewerkstelligt werden kann, der Befestigungsabsatz mit verpresst, so dass auch hier ein Form-, wenn nicht sogar ein Material-Schluss entsteht, der als Sicherung der Sensorvorrichtung am vordefinierten Ort dient.

Beginnt man das Verbinden in einem Zustand gemäß Fig. 4, so bewegt man das sockelförmige Kopplungsteil 20 in Fig. 4 nach unten. Zu einem gewissen Zeitpunkt wird das untere Ende des sockelförmigen Kopplungsteils 20 den Befestigungsabsatz 52 erreichen und an diesem anschlagen. Eine weitere Bewegung des sockelförmigen Kopplungsteils 20 nach unten führt nun die Sensorvorrichtung 30 anhand der Kontaktierung des Befestigungsabsatzes 52 weiter mit nach unten, bis die Sensorvorrichtung 30 an seiner Unterseite an der Leiterplatte 100 anliegt. Anschließend kann über eine Kraft, welche axial von oben auf das sockelförmige Kopplungsteil 20 aufgebracht wird und Abstützen der Leiterplatte 100, ein Verpressen des sockelförmigen Kopplungsteils 20 mit der Leiterplatte 100 erfolgen. Dabei kann es vorteilhaft sein, wenn nicht nur die Kontaktierelemente 24a in Nasenform sich verformen und vorteilhafterweise neben einem Formschluss auch ein Materialschluss mit der Leiterplatte 100 eingehen, sondern wenn auch der Befestigungsabsatz 52 sich verformt. Dabei kann neben einem Formschluss des verformten Befestigungsabsatzes 52 auch ein Materialschluss zwischen der Sicherungsvorrichtung 50, also dem Befestigungsabsatz 52 und der Leiterplatte 100 erfolgen. Damit wird eine irreversible Verbindung zwischen Leiterplatte 100 und sockelförmigen Kopplungsteil 20 sowie eine irreversible Verbindung, also eine irreversible Sicherung der Sensorvorrichtung 30 erzeugt.

Weiter ist der Haal-Sensor 34 bei der Ausführungsform der Fig. 4 im Uhrzeigersinn um 90° im Vergleich zu der Ausführungsform der Fig. 1 bis 3 gedreht. Damit ragen die Anschlussleitungen des Hall-Sensors 34 ebenfalls nach unten, also in Richtung der Verbindung mit der Leiterplatte 100. Damit ist es möglich, dass gleichzeitig mit dem Verpressen des sockelförmigen Kopplungsteils 20 auch die Messsignalleitung mit den Anschlüssen des Hall-Sensors 34 verbunden wird. Dafür könne insbesondere Vertiefungen in der Leiterplatte vorgesehen sein, welche für den Verpressvorgang die Anschlüsse des Hall-Sensors 34 aufnehmen und zur Kontaktierung dieser mit der Messsignalleitung dienen.

Im Übrigen funktioniert eine Anschluss- und Messvorrichtung 10 der Ausführungsform gemäß Fig. 4 identisch wie die Anschluss- und Messvorrichtung 10 gemäß der Fig. 1 bis 3, da auch hier eine Ausnehmung 36 in Form eines Schlitzes in dem Magnetflussmedium 32 vorgesehen ist, in welchem ein Hall-Sensor 34 angeordnet ist. Dieser kann in identischer Weise das induzierte Magnetfeld im Magnetflussmedium 32 wahrnehmen und damit indirekt den Strom in dem sockelförmigen Kopplungsteil 20 und damit die Stromversorgung der Leiterplatte 100 messen und überwachen.

Fig. 5 zeigt eine weitere Ausführungsform einer erfindungsgemäßen Anschluss- und Messvorrichtung 10. Auch hier ist ein Befestigungsabsatz 52 als Sicherungsvorrichtung 50 vorgesehen, jedoch ist dieser nicht unterhalb des sockelförmigen Kopplungsteils 20 sondern oberhalb von diesem angeordnet. Das sockelförmige Kopplungsteil 20 weist weiter einen Absatz auf, an welchem der Befestigungsabsatz 52 der Sicherungsvorrichtung 50 der Sensorvorrichtung 30 aufliegen kann. Durch das Aufsetzen der Stromversorgungsleitung 120 wird der Befestigungsabsatz 52 der Sicherungsvorrichtung 50 zwischen der Stromversorgungsleitung 120 und dem Absatz des sockelförmigen Kopplungsteils 20 eingeklemmt und damit eine örtliche Definition der Sensorvorrichtung 30 erzielt. Im Übrigen funktioniert die Sensorvorrichtung 30 mit einer Anordnung eines Hall-Sensors 34 in einer schlitzförmigen Ausnehmung 36 in einem Magnetflussmedium 32 in identischer Weise wie dies bereits zu den Fig. 1 bis 3 erläutert worden ist.

Eine weitere Änderung gemäß der Ausführungsform in Fig. 5 sind Kontaktierelemente 24c in Form eines Gewindes am unteren Ende des sockelförmigen Kopplungsteils 20. Dieses Gewinde ist als Kontaktierelement 24c schematisch dargestellt und dient dazu, in ein, nicht dargestelltes, Innengewinde einer Vertiefung einer Leiterplatte einzugreifen. Mit anderen Worten kann das sockelförmige Kopplungsteil 20 über die Kontaktierelemente 24c in Gewindeform in das Innengewinde einer Vertiefung in einer Leiterplatte 100 eingeschraubt werden. Das Einschrauben dient wie bereits voranstehend zu den anderen Ausführungsformen ausführlich erläutert, sowohl der mechanischen Befestigung des sockelförmigen Kopplungsteils 20 an der Leiterplatte 100, als auch der elektrischen Verbindung der beiden Elemente. Die Verwendung eines Gewindes als Kontaktierelement ist damit eine reversible Möglichkeit, die Anschluss- und Messvorrichtung 10 an der Leiterplatte 100 zu befestigen.

Fig. 6 zeigt eine Draufsicht einer weiteren Ausführungsform einer Anschluss- und Messvorrichtung 10. Bei dieser Ausführungsform sind die Konturen der Sensorvorrichtung 30 und des sockelförmigen Kopplungsteils 20 aneinander angepasst. So weist das sockelförmige Kopplungsteil 20 eine im Wesentlichen rechteckige, insbesondere quadratische Querschnittsstruktur auf, wodurch sich eine Außenkontur mit geraden zueinander rechtwinkligen Seitenflächen ergibt. Die Innenkontur der Sensorvorrichtung 30 ist an dieser Außenkontur derart angepasst, dass eine Öffnung in der ringförmigen Sensorvorrichtung 30 vorgesehen ist, die ebenfalls im Wesentlichen senkrecht zueinander stehende gerade Seitenflächen aufweist. Mit anderen Worten korrespondieren die Aussenkontur des sockelförmigen Kopplungsteils 20 und die Innenkontur der Sensorvorrichtung 30 nahezu vollständig miteinander. Damit kann der Abstand zwischen der Sensorvorrichtung 30 und dem sockelförmigen Kontaktteil 20 auf ein Minimum reduziert werden. Unnötiger Luftraum, der als nicht verwendbarer Bauraum verbleiben würde, ist auf diese Weise minimiert, wodurch die Kompaktheit der gesamten Anschluss- und Messvorrichtung 10 der Ausführungsform gemäß Fig. 6 auf ein Minimum reduziert wurde.

Auch bei der Ausführungsform gemäß Fig. 6 ist ein Hall-Element 34 in einer schlitzförmigen Ausnehmung 36 zwischen zwei Enden 30a und 30b des Magnetflussmediums 32 angeordnet, so dass in einer Weise das induzierte Magnetfeld im Magnetflussmedium 32 gemessen werden kann, wie dies bereits voranstehend zu den vorher beschriebenen Ausführungsformen im Detail erläutert worden ist.

Fig. 7 zeigt eine weitere Ausführungsform einer erfindungsgemäßen Anschluss- und Messvorrichtung 10, wobei hier wiederum eine Variation der Sicherungsvorrichtung 50 und eine Variation der Kontaktierelemente im Leiterplatten-Anschlussabschnitt 24 durchgeführt worden ist. Die Sicherungsvorrichtung 50 gemäß der Ausführungsform in Fig. 7 sichert die Sensorvorrichtung 30 über eine Schnapp-Rastverbindung an dem sockelförmigen Kopplungsteil 20. So befindet sich die Sensorvorrichtung 30 und damit auch die Sicherungsvorrichtung 50 bereits im gesicherten und damit eingerasteten Zustand an dem sockelförmigen Kopplungsteil 20. Um dahin zu gelangen, ist die Sicherungsvorrichtung 50 aus einem elastischen Material gebildet, so dass sie sich beim Aufschieben der Sensorvorrichtung 30 auf das sockelförmige Kopplungsteil 20 elastisch verformen und ein Aufschieben ermöglichen kann. Sobald die Sicherungsvorrichtung 50, welche hier in Form von Rastnasen ausgebildet ist, entsprechende korrespondierende Vertiefungen in dem sockelförmigen Kopplungsteil 20 erreicht, bewegen sich, durch die elastischen Rückstellkräfte angetrieben, die Nasen der Sicherungsvorrichtung 50 in diese Vertiefungen hinein und sichern in reversibler Weise die Sensorvorrichtung 30 in der dafür vorgesehenen Position. Auch hierbei handelt es sich also um eine reversible Sicherung, die, sofern gewünscht, wieder rückgängig gemacht werden kann, so dass ein Abnehmen der Sensorvorrichtung 30 von dem sockelförmigen Kopplungsteil 20 möglich ist.

Am unteren Sockelende des sockelförmigen Kupplungsteils 20 ist der Leiterplatten-Anschlussabschnitt 24 mit Kontaktierelementen 24b in Form einer Schnapp-Rastverbindung ausgebildet. Auch hier sind Rastvorsprünge vorgesehen, die im Wesentlichen den gesamten Umfang des sockelförmigen Kopplungsteils 20 am unteren Sockelende umlaufen. Die korrespondierende Vertiefung in der Leiterplatte 100 weist entsprechende ebenfalls korrespondierende Rastnasen auf, die in Eingriff mit den Rastnasen der Kontaktierelemente 24b der Schnapp-Rastmittel des sockelförmigen Kopplungsmittels 20 greifen können. Bewegt man nun die Anschluss-und Messvorrichtung 10 gemäß Fig. 7, welche bereits eine gesicherte Sensorvorrichtung 30 am sockelförmigen Kopplungsteil 20 aufweist, nach unten, so kann durch die Ausübung von einem Mindestmaß an Kraft die Anschluss- und Messvorrichtung 10, insbesondere das sockelförmige Kopplungsteil 20, in die Vertiefung der Leiterplatte 100 eingerastet werden. Je nach Materialwahl, Elastizitätsgrad, bzw. Festigkeit des jeweiligen Materials handelt es sich hierbei um eine reversible oder um eine irreversibel Verbindung zwischen sockelförmigem Kopplungsteil 20 und Leiterplatte 100. Ist zum Beispiel ein Aufbiegen einer der beiden Rastnasen nach dem Verrasten nicht mehr möglich, so kann eine Trennung des sockelförmigen Kopplungsteils 20 von der Leiterplatte 100 nur noch unter Zerstörung des Leiterplatten-Anschlussabschnitts 24 erfolgen. Bei einer derartigen Ausführungsform der Kontaktierung ist darauf zu achten, dass neben der mechanischen Befestigung des sockelförmigen Kopplungsteils 20 auch eine ausreichende elektrische Kontaktierung stattfinden.

Fig. 8 zeigt eine ähnliche Ausführungsform wie die Darstellung der Fig. 1 bis 3, jedoch sind hier zwei Modifikationen durchgeführt. Zum einen handelt es sich bei der Sensorvorrichtung 30 um eine Modifikation der Sensorart, so dass zumindest abschnittsweise um das Magnetflussmedium 32 eine Spule 40 gewickelt ist. Nicht weiter dargestellt sind die Anschlüsse der Spule 40 an die Messsensorik, welche auch über Messleitungen mit dem Hall-Sensor 34 verbunden ist. Auf diese Weise ist eine Sensorvorrichtung gegeben, mit welcher sogenannte bekannte "Closed-Loop-Messungen" möglich sind. Damit ist eine Kompensation von physikalischen Effekten möglich, die die Sensibilität des Hall-Sensors und damit die Genauigkeit der gesamten Sensorvorrichtung 30 um ein Vielfaches erhöht.

Weiter ist die Ausführungsform gemäß Fig. 8 hinsichtlich der Verbindung zwischen dem sockelförmigen Kopplungsteil 20 und der Leiterplatte 100 modifiziert. So sind hier im Leiterplatten-Anschlussabschnitt 24 Kontaktierelemente 24d in Form einer Klebeverbindung vorgesehen. Die Klebeverbindung kann dabei sowohl in Form eines einfachen Vulkanisierungsklebers erfolgen, wie auch durch Unterstützung anderer Adhäsionskräfte über Haftvermittler hergestellt werden. Die Klebeverbindung ist üblicherweise als irreversible Verbindung des Leiterplatten-Anschlussabschnitts 24 des sockelförmigen Kopplungsteils 20 an die Leiterplatte 100 zu verstehen.

In den Fig. 9A und 9B ist eine besondere Ausführungsform hinsichtlich der Sicherungsvorrichtung 50 dargestellt. Fig. 9A zeigt dabei die Situation während des Herstellens der Sicherung, während Fig. 9B die gesicherte Position zeigt. Bei dieser Ausführungsform ist die Sicherungsvorrichtung 50 in Form einer nutförmigen Vertiefung in dem sockelförmigen Kopplungsteil 20 und einer korrespondierenden Nase der Sensorvorrichtung 30 zu erkennen. Die Nase, wie auch die nutförmige Vertiefung der Sicherungsvorrichtung 50 sind dabei jeweils angeschrägt. Die Anstellwinkel der jeweiligen Schräge befinden sich im selbsthemmenden Bereich, so dass bei einem Zusammenschieben aus einer Position wie in Fig. 9A gestellt, bis in eine Situation wie in Fig. 9B dargestellt, die beiden angewinkelten Flächen der Nut bzw. der Nase miteinander in Kontakt treten. Durch die Ausbildung des Anstellwinkels in einem selbsthemmenden Bereich wird die Sensorvorrichtung 30 daran gehindert, wieder die Position aus Fig. 9B nach oben zu verlassen. Eine Weiterbewegung nach unten ist aufgrund der geometrischen Verhältnisse nicht möglich, da hier eine Materialsperre der aufeinander anliegenden angestellten Flächen vorliegt. Jedoch kann eine Bewegung der Sensorvorrichtung 30 nach oben ab einer definierten Kraft erfolgen, welche die Reibungskraft der beiden aufeinander liegenden selbstgehemmten Flächen überwindet. Damit handelt es sich um eine reversible Sicherungsvorrichtung 50.

In Fig. 10 ist eine Ausführungsform einer erfindungsgemäßen Leiterplatte 100 dargestellt. Auf dieser Leiterplatte 100 sind schematisch Leiterbahnen 110 dargestellt, die zu nicht mehr dargestellten Funktionsbauteilen auf der Leiterplatte 100 führen. Diese Leiterbahnen 110 versorgen die nicht dargestellten Funktionsbauteile mit Strom, welche sie von einem zentralen Stromversorgungsanschluss auf der Leiterplatte 100 erhalten. Als Stromversorgungsanschluss ist auf der Leiterplatte 100 eine Anschluss-und Messvorrichtung 10 gemäß der vorliegenden Erfindung vorgesehen. Die Anschluss- und Messvorrichtung 10 ist dabei insbesondere nach einer der Varianten gemäß den voranstehend erläuterten Fig. 1 bis 9 ausgebildet. Somit ist ein Hall-Sensor 34 in einer schlitzförmigen Ausnehmung 36 einer Sensorvorrichtung 30 vorgesehen, welcher ein induziertes Magnetfeld in einem Magnetflussmedium 32 der Sensorvorrichtung 30 erkennen und in Abhängigkeit der Variation des induzierten Magnetfelds variierte Stromsignale abgeben kann.

Wie aus Fig. 11, einer Weiterbildung der Ausführungsform der Fig. 10, zu erkennen ist, ist der Hall-Sensor 34 mit einer Regelvorrichtung 200 und einer Stromquelle 300 verbunden. So kann eine tatsächliche Regelung der Stromversorgung der Leiterplatte 100 erfolgen. Ein Regelkreis ist möglich, welcher auf der einen Seite über den Hall-Sensor 34 indirekt den Strom misst, welcher über die Anschluss- und Messvorrichtung 10 in die Leiterplatte 100 einfließt. Dieser gemessene Strom wird mit einem Sollwert für den benötigten Strom der Leiterplatte 100 verglichen und der Vergleich als Steuersignal an die Stromversorgung 300 übermittelt. Die Stromversorgung 300 erhöht, bzw. reduziert die Spannung und damit den Stromfluss welcher zur Leiterplatte 100 transportiert wird. Dieser Regelkreis ermöglicht es, in der Leiterplatte 100 konsequent und konstant einen gewünschten Wert der Stromversorgung einzuhalten.

Die voranstehend erläuterten Ausführungsbeispiele beschreiben die vorliegende Erfindung nur exemplarisch. Dabei ist insbesondere darauf hinzuweisen, dass einzelne beschriebene Merkmale der einzelnen Ausführungsformen, insbesondere die Kontaktierelemente oder die Ausbildung der Sicherungsvorrichtungen im technischen Sinn frei untereinander oder mit weiteren, nicht ausführlich erläuterten technischen Möglichkeiten im Rahmen der vorliegenden Erfindung kombiniert werden können. Somit schränken die beispielhaften Ausführungen gemäß dieser Beschreibung die Erfindung nicht ein.

### Bezugszeichenliste

- 10: Anschluss- und Messvorrichtung
- 20: sockelförmiges Kopplungsteil
- 21: Aussenkontur des sockelförmigen Kopplungsteils
- 22: Leitungs-Anschlussabschnitt
- 24: Leiterplatten-Anschlussabschnitt
- 24a: Kontaktierelemente in Form von Nasen
- 24b: Kontaktierelemente in Form einer Schnapp-Rast-Verbindung
- 24c: Kontaktierelemente in Form eines Gewindes
- 24d: Kontaktierelement in Form einer Klebeverbindung
- 30: Sensorvorrichtung
- 30a: erstes Ende des Magnetflussmediums
- 30b: erstes Ende des Magnetflussmediums
- 31: Innenkontur der Sensorvorrichtung
- 32: Magnetflussmedium
- 34: Hall-Sensor
- 36: Ausnehmung
- 38: elektrisch isolierende Beschichtung
- 40: Spule
- 50: Sicherungsvorrichtung
- 52: Befestigungsabsatz
- 100: Leiterplatte
- 110: Leiterbahn
- 120: Stromversorgungsleitung
- 130: Verschraubung
- 200: Regelvorrichtung
- 300: Stromquelle

## Patentansprüche

1. Anschluss- und Messvorrichtung (10) für den elektrischen Anschluss einer Stromversorgungsleitung (120) an einer Leiterplatte (100) und die Überwachung des über die Anschluss- und Messvorrichtung (10) zugeführten elektrischen Stroms, aufweisend:
■ ein sockelförmiges Kopplungsteil (20) mit einem Leitungs-Anschlussabschnitt (22) für den Anschluss der Stromversorgungsleitung (120) und mit einem an einem Sockelende ausgebildeten Leiterplatten-Anschlussabschnitt (24) für den Kontakt mit der Leiterplatte (100), und mit einer elektrischen Verbindung zur elektrischen Kopplung des Leitungs-Anschlussabschnitts (22) mit dem Leiterplatten-Anschlussabschnitt (24),
■ eine Sensorvorrichtung (30), die ein die elektrische Verbindung umlaufendes und eine Ausnehmung (36) aufweisendes Magnetflussmedium (32) und einen in der Ausnehmung (36) angeordneten Hall-Sensor (34) mit einem Anschluss zu einer elektrischen Messsignal-Leitung aufweist, so dass dieser in Abhängigkeit von der Stärke des im Magnetflussmedium (32) induzierten Magnetfelds ein elektrisches Signal zur Überwachung des an das Kopplungsteil zugeführten elektrischen Stroms erzeugt.

2. Anschluss- und Messvorrichtung (10) nach Anspruch 1, **dadurch gekennzeichnet, dass** die Sensorvorrichtung (30) ringförmig ausgestaltet ist und das Magnetflussmedium (32) der Sensorvorrichtung (30) das sockelförmige Kopplungsteil (20) in einem Umfangsbereich des sockelförmigen Kopplungsteils (20) umgibt, welcher größer oder gleich 180° ist, sowie der Hall-Sensor (34) bezogen auf die Umfangsrichtung des Magnetflussmediums (32) zwischen den beiden Enden (30a, 30b) des Magnetflussmediums (32 angeordnet ist.

3. Anschluss- und Messvorrichtung (10) nach Anspruch 2, **dadurch gekennzeichnet, dass** die bezogen auf die Umfangsrichtung des Magnetflussmediums (32) beiden Enden (30a, 30b) des Magnetflussmediums (20) eine Ausnehmung (36) in Form eines Schlitzes bilden, in dem der Hall-Sensor (34) angeordnet ist, wobei die schlitzförmige Ausnehmung(36) bezogen auf den Umfang des Anschlusselements (20) kleiner oder gleich 10° ist.

4. Anschluss- und Messvorrichtung (10) nach einem der vorangegangenen Ansprüche, **dadurch gekennzeichnet, dass** die Sensorvorrichtung (30) als gegenüber dem sockelförmigen Kopplungsteil (20) separates Bauteil ausgeführt ist.

5. Anschluss- und Messvorrichtung (10) nach einem der vorangegangenen Ansprüche, **dadurch gekennzeichnet, dass** die Sensorvorrichtung (30) eine elektrisch isolierende Beschichtung (38) aufweist, die zumindest die Kontaktbereiche zwischen dem Magnetflussmedium (32) der Sensorvorrichtung (30) und dem sockelförmigen Kopplungsteil (20) elektrisch voneinander isoliert.

6. Anschluss- und Messvorrichtung (10) nach einem der vorangegangenen Ansprüche, **dadurch gekennzeichnet, dass** die Sensorvorrichtung (30) eine dem sockelförmigen Kopplungsteil (20) zugewandte Innenkontur (31) aufweist, deren Form zumindest abschnittsweise der Form der Aussenkontur (21) des sockelförmigen Kopplungsteils (20) gleicht.

7. Anschluss- und Messvorrichtung (10) nach einem der vorangegangenen Ansprüche, **dadurch gekennzeichnet, dass** das sockelförmige Kopplungsteil (20) als eigenes Bauteil ausgebildet ist, so dass das ende desselben, an dem der Leiterplatten-Anschlussabschnitt (24) gelegen ist, zum Aufsetzen auf eine Leiterplatte ausgebildet und mit Kontaktierelementen (24a, 24, 24c, 24d) zum elektrischen Kontaktieren mit der Leiterplatte (100) versehen ist.

8. Anschluss- und Messvorrichtung (10) nach einem der vorangegangenen Ansprüche, **dadurch gekennzeichnet, dass** die Sensorvorrichtung (30) eine mechanische Sicherungsvorrichtung (50) aufweist, welche die Sensorvorrichtung (30) an dem sockelförmigen Kopplungsteil (20) befestigt, und dass insbesondere die Sensorvorrichtung (30) zumindest einen Befestigungsabsatz (52) aufweist, der derart gestaltet ist, dass auf eine erste Anlageseite desselben das Kopplungsteil (20) aufsetzbar ist und dass eine zweite, zur ersten Anlageseite entgegen gesetzt gerichtet zweite Anlageseite auf die Leiterplatte insbesondere flächig oder formschlüssig aufsetzbar ist, so dass wenigstens ein Abschnitt des Befestigungsabsatzes (52) beim elektrischen Kontaktieren des sockelförmigen Kopplungsteils (20) mit der Leiterplatte (100) mittels Kontaktierelementen (24a, 24, 24c, 24d) zwischen dem sockelförmigen Kopplungsteil (20) und der Leiterplatte (100) gelegen ist und durch das Kontaktieren des sockelförmigen Kopplungsteils (20) mit der Leiterplatte (100) die Sensorvorrichtung (30) relativ zum sockelförmigen Kopplungsteil (20) örtlich und/oder in ihrer Lage festgelegt wird.

9. Anschluss- und Messvorrichtung (10) nach einem der vorangegangenen Ansprüche, **dadurch gekennzeichnet, dass** die Sensorvorrichtung (30) eine elektrisch leitende Spule (40) zur Ausbildung des Magnetflussmediums aufweist, deren Wicklungen um das Magnetflussmedium (32) der Sensorvorrichtung (30) gewickelt ist.

10. Leiterplatte (100) aufweisend elektrische Leiterbahnen (110) sowie eine Anschluss- und Messvorrichtung (10) für den Anschluss einer Stromversorgungsleitung (120) an die Leiterplatte (100) nach einem der voranstehenden Ansprüche,

11. Sensorvorrichtung (30) aufweisend zumindest ein Magnetflussmedium (32) mit einer ringförmigen Ausbildung, die derart ausgestaltet ist, dass bei Stromfluss durch ein elektrisch leitendes Material, welches sich durch das Innere der ringförmigen Ausbildung des Magnetflussmediums (30) erstreckt, ein Magnetfeld in dem Magnetflussmedium (32) induziert wird, und die einen Hall-Sensor (34) aufweist, welcher derart angeordnet ist, dass er in Abhängigkeit von der Feldstärke des im Magnetflussmedium (32) induzierten Magnetfelds ein elektrisches Signal erzeugt.

12. Sensorvorrichtung (30) nach Anspruch 11, **dadurch gekennzeichnet, dass** die Sensorvorrichtung (30)ringförmig ausgestaltet ist und das Magnetflussmedium (32) der Sensorvorrichtung (30) das sockelförmige Kopplungsteil (20) in einem Umfangsbereich des sockelförmigen Kopplungsteils (20) umgibt, welcher größer oder gleich 180° ist, sowie der Hall-Sensor (34) bezogen auf die Umfangsrichtung des Magnetflussmediums (32) zwischen den beiden Enden (30a, 30b) des Magnetflussmediums (32 angeordnet ist.
